## Europäisches Patentamt

## European Patent Office

## Office européen des brevets

(11) Veröffentlichungsnummer: **0 588 206 A1**

# EUROPÄISCHE PATENTANMELDUNG

(21) Anmeldenummer: **93114310.1**

(22) Anmeldetag: **06.09.93**

(51) Int. Cl.5: **H03G 3/20**

(30) Priorität: **15.09.92 DE 4230801**
**05.12.92 DE 4241028**

(43) Veröffentlichungstag der Anmeldung:
**23.03.94 Patentblatt 94/12**

(84) Benannte Vertragsstaaten:
**BE DE FR GB IT NL**

(71) Anmelder: **ANT Nachrichtentechnik GmbH**
**Gerberstrasse 33**
**D-71522 Backnang(DE)**

(72) Erfinder: **Drinda, Klaus, Dipl.-Ing.**
**Tannenweg 12**
**D-71522 Backnang(DE)**

(54) **Verfahren zur Aufbereitung eines Reglerstellsignals sowie Anordnung und Verwendung.**

(57) Zur Konstantregelung von Hochfrequenzsigna-len, beispielsweise n-PSK-Signalen in der Zwischen-frequenzebene, werden AGC-Verstärker eingesetzt. Bei stark verrauschten Signalen wird die Regelung durch Rauschanteile ungünstig beeinflußt.

Zur Kompensation dieser Rauschanteile bei der Aufbereitung des Stellsignals wird das störbehaftete Hochfrequenzsignal schmalbandig gefiltert (SF) und zwar an einer Stelle, wo der Rauschleistungsanteil größer ist als der Nutzsignalanteil. Das so gewonne-ne Korrektursignal wird dann, gegebenenfalls nach entsprechender Gewichtung, vom üblicherweise auf-bereiteten Stellsignal subtrahiert.

Fig. 1

Die Erfindung geht aus von einem Verfahren gemäß dem Oberbegriff des Patentanspruchs 1 bzw. von einer Anordnung gemäß dem Oberbegriff des Patentanspruchs 6.

In der DE 26 31 460 C2 sind mehrere Verfahren zur Erzeugung eines Steuersignals in einem mit Störungen behafteten Empfangskanal dargestellt. Dort wird ein AGC-Verstärker als Stellglied in Abhängigkeit von Steuersignalen beeinflußt, die durch Quadrierung (Gleichrichtung) und anschließender Tiefpaßfilterung des Hochfrequenzsignals selbst, dem herabgemischtem Hochfrequenzsignal oder aus den I und Q Komponenten des demodulierten Hochfrequenzsignals gewonnen werden. Bei der Gewinnung direkt aus dem Hochfrequenzsignal ist die Störleistung im Regelkreis wirksam. Bei der Gewinnung aus dem herabgemischten Signal bzw.den demodulierten Komponenten läßt sich zwar der Einfluß der Störleistung im Regelkreis unterdrücken, jedoch ist diese Methode aufwendig und führt zu Regelverzögerungen. Auch ist ein solcher HF-Demodulator insbesondere bei n-PSK-Signalen kritisch hinsichtlich der Dimensionierung seiner Regelschleifen, so daß eine zusätzliche integrierte Regelschleife für die AGC-Regelung oft nicht vertretbar ist.

Aufgabe der Erfindung ist es das Verfahren ausgehend vom Oberbegriff des Patentanspruchs 1 bzw. die Anordnung ausgehend vom Oberbegriff des Patentanspruchs 6 so weiterzubilden, daß der Einfluß der Störleistung im Regelkreis unterdrückt wird, ohne daß im Regelkreis unerwünschte Signalverzögerungen oder - verzerrungen auftreten, insbesondere für den Fall, daß der Signalstörabstand C/N < 10 dB ist. Diese Aufgabe wird bezüglich des Verfahrens durch die Merkmale des Patentanspruchs 1 und bezüglich der Anordnung durch die Merkmale des Patentanspruchs 6 gelöst. Die Ansprüche 10 und 11 zeigen bevorzugte Anwendungen des Verfahrens/der Anordnung auf. Die übrigen Ansprüche betreffen Weiterbildungen des Verfahrens bzw. der Anordnung.

Die Erfindung beruht auf der Erkenntnis, daß insbesondere bei Störungen des Nutzsignals in Form von Rauschen die spektrale Leistungsdichte des Rauschens beim Maximalwert (maximaler Amplitudenwert) des Nutzsignals gleich oder proportional ist zur spektralen Leistungsdichte des Rauschens an einer Stelle mit relativ kleinem hochfrequenten Störabstand C/N (carrier to noise), z.B 15 dB darunter. Die Erfindung ermöglicht die Verringerung des Rauscheinflusses auf die Amplitudenregelung des Nutzinals (C) bei Störabständen (C/N) kleiner 10 dB.

Aus diesem Grunde ist es möglich durch eine schmalbandige Auswertung des verrauschten Signals an dieser Stelle ein Korrektursignal zu erzeugen, welches bei der Aufbereitung des Stellsignals in dem Maße zugesetzt wird, daß nur noch ein zu C proportionales Signal als Regler-Stellsignal erscheint. Für ein so aufbereitetes Regler-Stellsignal erscheint am Ausgang des Reglers ein konstanter Ausgangspegel, welcher weitgehend unbeeinflußt vom Rauschen ist.

Die Nachteile herkömmlicher AGC-Verstärker, wo der Ausgangspegel abhängig vom Rauschanteil ist, wirken sich daher nicht aus. Die Erfindung eignet sich vorteilhaft bei der Pegelregelung von verrauschten n-PSK, z. B. BPSK oder QPSK, Signalen in der Zwischenfrequenzebene. Als Vorstufe eines n-PSK-Demodulators sorgt die Anordnung/das Verfahren gemäß der Erfindung dafür, daß im Demodulatorkreis keine zusätzlichen kritischen Regelpfade erscheinen wie etwa bei der Anordnung gemäß der DE 26 31 460 C2.

Das Verfahren/die Anordnung gemäß der Erfindung fordert keinerlei Einschränkungen hinsichtlich der Bandbreite des AGC-Verstärkers im Hauptsignalweg. Dies wirkt sich insbesondere günstig auf einen nachgeschalteten Demodulator aus. Mit der Erfindung läßt sich eine optimale Kompensation von Störanteilen (Rauschanteilen) bei der Aufbereitung des Stellsignals leicht einstellen.

Anhand der Zeichnungen werden Ausführungsbeispiele der Erfindung näher erläutert. Es zeigen

Figur 1 ein Blockschaltbild einer Anordnung gemäß der Erfindung,

Figur 2 das Spektrum des Hochfrequenzsignals mit Lage der Schmalbandfilterung und

Figur 3 ein Blockschaltbid einer modifizierten Anordnung gemäß der Erfindung.

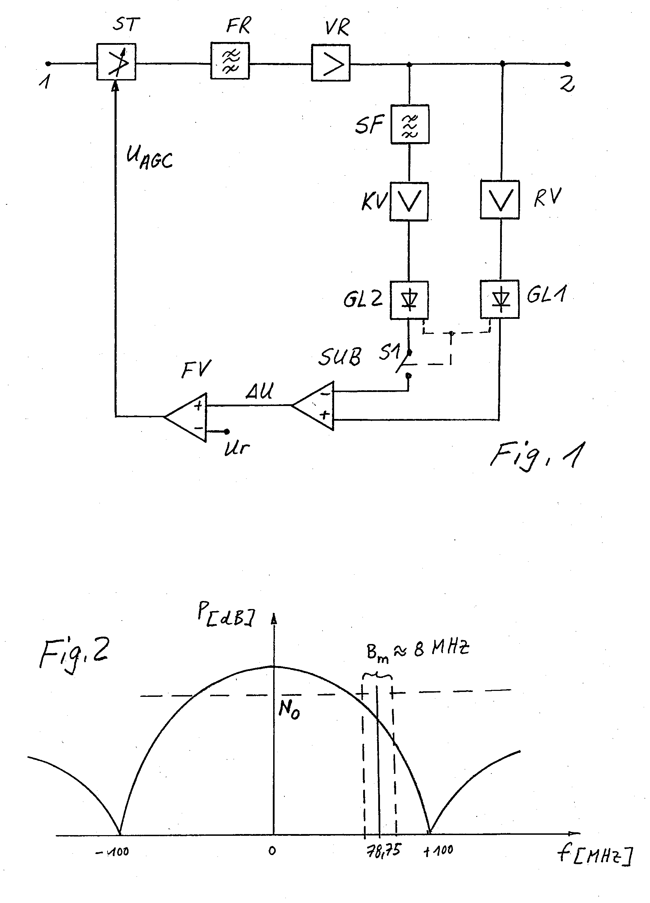

Beim Blockschaltbild gemäß Figur 1 wird bei Punkt 1 ein störbehaftetes, insbesondere verrauschtes Hochfrequenzsignal, beispielsweise in der ZF-Ebene zugeführt. Das Hochfrequenzsignal kann beispielsweise ein BPSK, QPSK oder ein FM-Signal sein, dessen spektrale Leistungsdichte ausgehend von einem Maximalwert, z. B. in Bandmitte, abfällt. Dieses Hochfrequenzsignal, dessen Leistungsspektrum in Figur 2 dargestellt ist, wird einem Stellglied ST in Form eines AGC-Verstärkers zugeführt. Anschließend wird es mittels eines Filters FR, dessen Bandbreite $B_R$ z. B. 200 MHz beträgt, breitbandig gefiltert und mittels dem Verstärker VR verstärkt.

Am Ausgang des Reglers steht das Hochfrequenzsignal, das auf konstantem Ausgangspegel geregelt wurde, am Punkt 2 zur Weiterverarbeitung, beispieswese zur Demodulation durch einen n-PSK Demodulator, zur Verfügung.

Zur Erzeugung des Stellsignals für das Stellglied wird das ausgangsseitige Hochfrequenzsignal verstärkt (Verstärker RV), gleichgerichtet (Gleichrichter GL1) und über eine Verknüpfungsstufe SUB einem Fehlerverstärker FV zugeführt, welcher das ausgewertete Hochfrequenzsignal mit einem Referenzwert Ur vergleicht und in Abhängigkeit davon, in welchem Maße das ausgewertete Hochfrequenzsignal den Referenzwert übersteigt, das Stellsignal in Form einer Regelspannung $U_{AGC}$ für den AGC-Verstärker bereitstellt. Allein mit dieser Regelschleife wäre der Pegel des Ausgangssignals am Punkt 2 zwar konstant, aber in höchstem Maße von der überlagerten Störung, bzw. dem Rauschen, abhängig. Um diese Abhängigkeit des Ausgangssignals vom Rauschen zu unterdrücken, wird erfindungsgemäß ein Korrektursignal erzeugt, welches über die Verknüpfungsstufe SUB bei der Bildung des Stellsignals berücksichtigt wird. Zur Gewinnung des Korrektursignals wird das Ausgangssignal am Punkt 2 des Reglers schmalbandig gemessen; d.h. über ein Schmalbandfilter SF mit der Bandbreite $B_m$ von beispielsweise 8MHz erfaßt. Für die Stelle, an der diese Schmalbandfilterung bezüglich dem Hochfrequenzsignal vorgenommen wird, gilt:

$$C_m/N_m \ll C/N,$$

wobei C/N den Gesamtstörabstand im Signalweg 1-2 darstellt und der Index m die Stelle der Schmalbandfilterung (Fig 2) angibt. Obige Bedingung ist für die Meßstelle - Frequenzablage von der Mittenfrequenz des störbehafteten Hochfrequenzsignals- bei + 78,75 MHz bezogen auf die Bandmitte bei 0 MHz mit dem Maximum der spektralen Leistungsdichte erfüllt. An dieser Stelle ist das Nutzsignal C um 15 dB gegenüber dem Maximum abgesenkt. Wie Figur 2 weiter zeigt, ist bei einer Rauschleistungsdichte $N_o$ (gestrichelt) in der gemessenen Bandbreite $B_m$ des Schmalbandfilters SF der Rauschleistungsanteil $N_m$ größer als der Nutzsignalanteil $C_m$. Aus diesem Grunde eignet sich die Erfindung zur Verbessung der Amplitudenregelung für Signale für die gilt: Rauschleistung $N_m$ > $C_m$. Bei einem Gesamtstörabstand C/N, bezogen auf die Bandbreite $B_R$, ist ab einem Wert C/N $\leq$ 10 dB eine merkliche Verbesserung des Regelverhaltens möglich.

Nach der Schmalbandfilterung wird das Korrektursignal verstärkt (Verstärker KV), gleichgerichtet (Gleichrichter GL2) und ebenfalls der Verknüpfungsstufe SUB zugeführt. Diese Verknüpfungsstufe SUB ist als Subtrahierer ausgebildet, dem das Korrektursignal am Minuseingang zugeführt wird. Der Störanteil, bzw. der Rauschanteil, des Hochfrequenzsignals läßt sich in der Regelschleife dann kompensieren, wenn das Korrektursignal dem Subtrahierer mit dem Gewichtungsfaktor $g_m$ zugeführt wird, der gemäß den nachfolgenden Beziehungen gewählt ist.

Die Rauschleistung $P_m$ an der Meßstelle ergibt sich zu:

$$P_m = N_o \cdot B_m \cdot g_m$$

mit $N_o$ = spektrale Rauschleistungsdichte [dB/Hz].

Für die Spannung $U_m$ nach der Gleichrichtung durch den Gleichrichter GL2 mit quadratischer Kennlinie gilt:

$$U_m \sim P_m .$$

Ebenso gilt für das breitbandige störbehaftete Hochfrequenzsignal:

$$P_R = C + N_R = C + N_o \cdot B_R$$

und

$$U_R \sim P_R .$$

Für die Spannung $\Delta U$ am Ausgang des Subtrahierers SUB ergibt sich dann:

$$\Delta U = U_R - U_m = C + N_o B_R - N_o B_m \cdot g_m.$$

Wenn die Bedingung

$$N_o B_R = N_o B_m \cdot g_m$$

erfüllt ist, ist $\Delta U$ nur noch von C, also dem rauschbefreiten Nutzsignal, abhängig und der Ausgangspegel am Punkt 2 ist unabhängig vom Rauschanteil.

Diese Bedingung ist erfüllt wenn gilt:

$$g_m = B_R/B_m.$$

Die Einstellung des Gewichtsfaktors $g_m$ nach obiger Bedingung kann auf einfache Weise durch Abgleich bzw. Einstellung des Verstärkers KV vorgenommen werden. Die Gewichtung des Korrektursignals gemäß obigen Bedingungen kann natürlich prinzipiell auch nach der Gleichrichtung vorgenommen werden. Der Verstärker KV fungiert somit als Amplitudengewichtungsnetzwerk AGN.

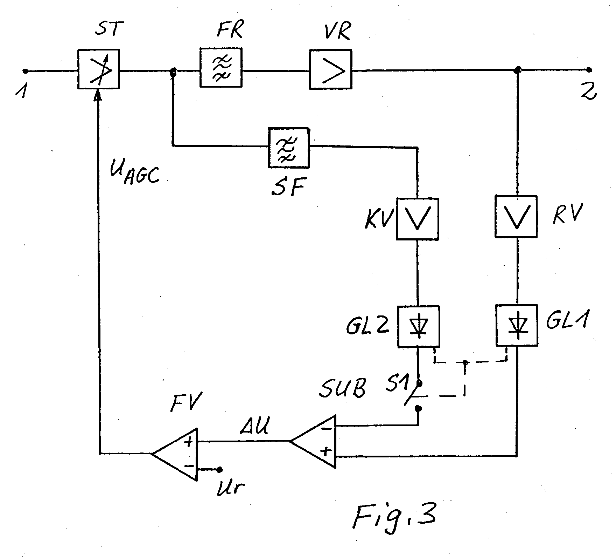

In Figur 3 ist eine modifizierte Ausführungsform dargestellt. Für die Erzeugung des Korrektursignals wird nicht das Ausgangssignal am Punkt 2 herangezogen, sondern das Ausgangssignal des AGC-Verstärkers vor der breitbandigen Filterung mittels Filter FR; d.h. in diesem Falle erfolgt eine Außerbandrauschmessung. Hierbei ist zu beachten, daß Nachbarsignale oder Oberwellen die Messung nicht ungünstig beeinflußen dürfen. Bei geringer Gefahr von Oberwellen und/oder der Annahme, daß Nachbarkanäle keinen Einfluß haben, läßt sich das Bandfilter FR sogar entbehren.

Bisher wurde vorausgesetzt, daß das Signal-Rauschverhältnis C/N relativ klein ist, z. B. < 2 dB für Kommunikationsverbindungen zu Satelliten. Bei günstiger Ausbreitung, insbesondere bei geringen Dämpfungsverlusten, ist es vorteilhaft das Korrektursignal bei der Aufbereitung des Stellsignals unberücksichtigt zu lassen. Dies kann beispielsweise dadurch realisiert werden, daß im Korrektursignalzweig ein Schalter S1 vorgesehen ist, der den Korrekturzweig unterbricht, wenn der Signal-Störabstand des Hochfrequenzsignals größer ist als ein vorgegebener Schwellwert.

Ein Kriterium für das Erreichen eines solchen Schwellwertes kann beispielsweise aus den Ausgangssignalen der Gleichrichter GL1 und GL2 gewonnen werden. Der Schalter S1 trennt den Korrektursignalzweig beispielsweise dann auf wenn gilt:

$C/N \geq 10\ dB$.

**Patentansprüche**

1. Verfahren zur Aufbereitung eines Reglerstellsignals für den Regler eines störbehafteten Hochfrequenzsignals, dadurch gekennzeichnet, daß zur Bildung des Stellsignals ein Korrektursignal herangezogen wird, das aus dem störbehafteten Hochfrequenzsignal abgeleitet ist und bei dem die Rauschleistung die Signalleistung, insbesondere innerhalb der Meßbandbreite ($B_m$) für das Korrektursignal, übersteigt.

2. Verfahren nach Anspruch 1, dadurch gekennzeichnet, daß das Korrektursignal durch schmalbandige Messung des störbehafteten Hochfrequenzsignals an einer Stelle gewonnen wird, wo die spektrale Leistungsdichte des Hochfrequenzsignals klein ist.

3. Verfahren nach Anspruch 1 oder 2, dadurch gekennzeichnet, daß das störbehaftete Hochfrequenzsignal zum einen nach breitbandiger Filterung oder ungefiltert gleichgerichtet wird und zum anderen nach schmalbandiger Filterung außerhalb der Bandmitte oder dem Maximum der spektralen Leistungsdichte ebenfalls gleichgerichtet wird zur Aufbereitung des Korrektursignals und daß das Korrektursignal vom Signal, das aus dem breitbandigen oder ungefilterten Hochfrequenzsignal nach Gleichrichtung gewonnen wird, subtrahiert wird.

4. Verfahren nach Anspruch 3, dadurch gekennzeichnet, daß das Korrektursignal vor der Subtraktion so gewichtet wird, daß das aus der Subtraktion gewonnene Stellsignal den Regler so steuern kann, daß am Reglerausgang ein Signal konstanten Pegels erscheint, welches von Störanteilen des Hochfrequenzsignals weitgehend unbeeinflußt ist.

5. Verfahren nach einem der Ansprüche 1 bis 4, dadurch gekennzeichnet, daß das Korrektursignal bei der Aufbereitung des Stellsignals unterdrückt wird, wenn der Signal-Störabstand des Korrektursignals größer ist als ein vorgegebener Schwellwert.

6. Anordnung zur Regelung, insbesondere zur Pegelregelung eines störbehafteten Hochfrequenzsignals, gekennzeichnet durch
   - ein Schmalbandfilter (SF) für das störbehaftete Hochfrequenzsignal, dessen Frequenzablage von der Mittenfrequenz des störbehafteten Hochfrequenzsignals so gewählt ist, daß gilt: $N_m > C_m$ mit $N_m$ = Rauschleistung im Durchlaßbereich des Schmalbandfilters (SF), $C_m$ = mittlere spektrale Signalleistungsdichte im Durchlaßbereich des Schmalbandfilters (SF).
   - eine Verknüpfungsstufe (SUB) zur Verknüpfung des breitbandig oder ungefilterten störbehafteten Hochfrequenzsignals mit dem schmalbandgefilterten Signal,
   - eine Stellsignalaufbereitungsstufe (FV), welche eingangsseitig mit dem Ausgang der Verknüpfungsstufe (SUB) und ausgangsseitig mit dem Steuereingang des Regler-Stellgliedes (ST) verbunden ist.

7. Anordnung nach Anspruch 6, gekennzeichnet durch die Ausbildung der Verknüpfungsstufe als Subtrahierer (SUB).

8. Anordnung nach Anspruch 6 oder 7, gekennzeichnet durch jeweils einen Gleichrichter (GL1, GL2) im Signalweg des schmalbandgefilterten Signals und des breitbandig oder ungefilterten störbehafteten Hochfrequenzsignals.

9. Anordnung nach einem der Ansprüche 6 bis 8, gekennzeichnet durch ein einstellbares Amplitudengewichtungsnetzwerk (AGN) im Signalweg des schmalbandgefilterten Signals.

10. Anwendung des Verfahrens der Anordnung nach einem der vorhergehenden Ansprüche zur AGC-Regelung eines rauschbehafteten Hochfrequenzsignals, insbesondere eines n-PSK Zwischenfrequenzsignals.

11. Anwendung des Verfahrens/der Anordnung nach einem der Ansprüche 1 bis 9 für einen AGC-Regler, welchem ein rauschbehaftetes Hochfrequenzsignal, insbesondere ein n-PSK Zwischenfrequenzsignal zugeführt ist, und welcher einem n-PSK Demodulator vorgeschaltet ist.

Fig. 1

Fig. 2

Fig. 3

Europäisches Patentamt

**EUROPÄISCHER RECHERCHENBERICHT**

Nummer der Anmeldung

EP 93 11 4310

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | PATENT ABSTRACTS OF JAPAN vol. 9, no. 181 (E-331)26. Juli 1985 & JP-A-60 051 310 (NIPPON DENKI K.K.) 22. März 1985 * Zusammenfassung * | 1-5 | H03G3/20 |
| A | | 6-11 | |
| A | PATENT ABSTRACTS OF JAPAN vol. 9, no. 318 (E-366)(2041) 13. Dezember 1985 & JP-A-60 152 111 (HITACHI MAIKURO COMPUTER ENGINEERING K.K.) 10. August 1985 * Zusammenfassung * | 1-11 | |
| A | IEEE TRANSACTIONS ON CONSUMER ELECTRONICS Bd. CE-37, Nr. 3 , August 1991 , NEW YORK (USA) Seite 671-675 XP263255 SAKAE SUGAYAMA E.A. 'Development of high-performance FM front end IC with improved interference characteristics.' * das ganze Dokument * | 1-11 | |
| A | DE-A-26 31 460 (SIEMENS A.G.) * das ganze Dokument * | 1-11 | |
| D,A | & DE-C-26 31 460 (SIEMENS A.G.) | | |

**RECHERCHIERTE SACHGEBIETE (Int.Cl.5)**

H03G

Der vorliegende Recherchenbericht wurde für alle Patentansprüche erstellt

| Recherchenort | Abschlußdatum der Recherche | Prüfer |
|---|---|---|
| DEN HAAG | 21. Dezember 1993 | Deconinck, E |